# EUROPEAN PATENT APPLICATION

(11) **EP 4 668 342 A1**
(43) Date of publication of application: **24.12.2025**
(21) Application number: 24756210.1
(22) Date of filing: 07.02.2024
(51) Int. Cl.: H01L 31/18, C25D 3/38, C25D 5/54

(54) **SOLAR CELL AND PREPARATION METHOD THEREFOR**

(30) Priority: 14.02.2023 CN 202310121468
(71) Applicant: Tongwei Solar (Chengdu) Co., Ltd., Chengdu, Sichuan 610299 (CN)
(72) Inventor: ZHANG, Qiaolin, Chengdu, Sichuan 610299 (CN); LIAO, Jie, Chengdu, Sichuan 610299 (CN); ZHU, Maoli, Chengdu, Sichuan 610299 (CN)
(74) Representative: Michalski Hüttermann & Partner Patentanwälte mbB
(86) International application number: PCT/CN2024/076568
(87) International publication number: WO 2024/169837

(57) **Abstract**

Provided in the present application are a solar cell and a preparation method therefor. The preparation method comprises the following steps: providing a solar cell substrate, wherein the surface of the solar cell substrate is provided with a copper seed layer; forming a negative photoresist layer on the copper seed layer; sequentially performing exposure and first development on the negative photoresist layer to form a patterned recess on the negative photoresist layer; performing degreasing treatment on the solar cell substrate that has been subjected to first development, so as to increase the solubility, in a developing solution, of negative photoresist at both sides of the bottom of the patterned recess; performing second development on the negative photoresist layer that has been subjected to degreasing treatment; and performing electroplating in the patterned recess that has been subjected to second development, so as to form copper grid lines. The preparation method in the present application can effectively alleviate the situation where copper grid lines have grid-line breakage and virtual grid-line breakage, thereby improving the production yield and conversion efficiency of solar cells.

## Description

This application claims priority to Chinese patent application No. 202310121468.5, entitled "SOLAR CELL AND PREPARATION METHOD THEREFOR" filed on February 14, 2023, the content of which is hereby incorporated by reference in its entirety.

### TECHNICAL FIELD

The present application relates to the field of photovoltaic technology, and in particular to a solar cell, and a method for manufacturing the same.

### BACKGROUND

Copper electroplating interconnect solar cell technology is a cost-reducing method for solar cell metallization, which replaces conventional silver gridline electrodes formed using a screen-printed silver paste with copper gridline electrodes prepared by copper electroplating interconnection. Cu is approximately 100 times cheaper than Ag, while having only slightly higher electrical resistance, thereby significantly reducing the metallization costs associated with expensive screen-printed silver paste. Therefore, copper electroplating interconnection to form gridline electrodes is currently one of the most cutting-edge and popular technologies in the photovoltaic industry.

Gridline thinning for solar cells is a trend in the solar cell industry. To reduce power loss caused by electrodes, it is necessary to increase the number of fine grid lines and reduce the width of fine grid lines. Reducing gridline width can reduce the required optimal gridline spacing, significantly reducing the total relative power loss from top-layer lateral current and the relative power loss from fine gridline shadowing, thereby reducing the total power loss caused by electrodes. Compared to conventional screen-printed silver grid lines, copper grid lines prepared by copper electroplating allows for thinner grid lines, further reducing electrode power loss.

However, the biggest challenge in the current thinning process of electroplated copper grid lines is the occurrence of gridline breakage and gridline false breakage. For copper grid lines with a width of 25 µm, the proportion of gridline breakage and gridline false breakage can be up to 90%, seriously affecting production yield and conversion efficiency of solar cells. Therefore, how to effectively reduce gridline breakage and gridline false breakage in copper electroplating process and improve the production yield of solar cells has become a key research direction in the art.

### SUMMARY

Accordingly, it is necessary to provide a solar cell and a method for manufacturing the same, which can reduce the proportion of gridline breakage and gridline false breakage generated in electroplating copper grid lines for solar cells, and improve the production yield of solar cells.

The technical solution provided in the present application is as follows.

In a first aspect, the present application provides a method for manufacturing a solar cell, including the following steps:
providing a solar cell substrate having a copper seed layer on a surface thereof;
forming a negative photoresist layer on the copper seed layer;
performing exposure and a first development on the negative photoresist layer sequentially to form a patterned recess on the negative photoresist layer;
performing a degreasing treatment on the solar cell substrate after the first development, so as to increase solubility of a negative photoresist at both sides of a bottom of the patterned recess in a developing solution;
performing a second development on the negative photoresist layer after the degreasing treatment; and
performing electroplating in the patterned recess after the second development to form copper grid lines.

According to the manufacturing method described above, after the first development, the degreasing treatment and the second development are sequentially performed, followed by electroplating copper grid lines. The degreasing treatment is performed to increase the solubility of the slightly exposed negative photoresist at both sides of the bottom of the patterned recess formed after the first development in the developing solution; and then the second development is performed to effectively remove the residual photoresist at both sides of the bottom of the patterned recess formed after the first development, increasing the contact area between the bottom of the copper grid lines and the copper seed layer, thereby reducing the defects of copper grid line breakage and gridline false breakage. Meanwhile, the cross-sectional morphology of the copper grid lines can be changed to a morphology with a narrow top and a wide bottom, which reduces the light-shielding area of the copper grid lines and light reflection. Therefore, the manufacturing method can improve the production yield of solar cells.

In some embodiments, the degreasing treatment includes the following step: treating the solar cell substrate with a degreasing solution containing a degreasing agent. As such, the solubility of the slightly exposed residual photoresist at both sides of the bottom of the patterned recess formed after the first development in the developing solution can be greatly increased, thereby facilitating the removal of the residual photoresist at both sides of the bottom of the patterned recess by subsequent development.

In some embodiments, the degreasing agent includes a surfactant.

In some embodiments, a volume fraction of the degreasing agent in the degreasing solution ranges from 0.5% to 3%.

In some embodiments, the degreasing solution further contains sulfuric acid. As such, the oxide layer on the surface of the copper seed layer at the bottom of the patterned recess can be effectively removed, which is conducive to electroplating copper grid lines on the copper seed layer in the patterned recess.

In some embodiments, a volume fraction of the sulfuric acid in the degreasing solution ranges from 0.5% to 2.5%. Under these volume fraction ranges, the degreasing agent and sulfuric acid can effectively increase the solubility of residual photoresist at both sides of the bottom of the patterned recess in the developing solution, and more effectively remove the oxide layer on the surface of the copper seed layer at the bottom of the patterned recess, thereby effectively reducing the high proportion of copper grid line breakage and gridline false breakage.

In some embodiments, the degreasing agent is a surfactant, and the degreasing solution consists of the degreasing agent, sulfuric acid, and a solvent. As such, not only the proportion of gridline breakage and gridline false breakage generated in electroplating copper grid lines for solar cells can be reduced, improving the production yield, but also the conversion efficiency of the solar cells can be further enhanced.

In some embodiments, the solvent in the degreasing solution is water.

In some embodiments, a temperature of the degreasing solution ranges from 35°C to 45°C. As such, the oxide layer on the surface of the copper seed layer can be effectively removed, and the solubility of residual photoresist at both sides of the bottom of the patterned recess can be effectively increased.

In some embodiments, a time period for the degreasing treatment ranges from 15 seconds to 30 seconds. As such, the oxide layer on the surface of the copper seed layer can be effectively removed, and the solubility of residual photoresist at both sides of the bottom of the patterned recess can be increased.

In some embodiments, a developing solution used in the second development includes one or more of a sodium carbonate solution and a potassium carbonate solution.

In some embodiments, a concentration of the developing solution used in the second development ranges from 10 g/L to 15 g/L. By using the above developing solution for the second development, residual photoresist at both sides of the bottom of the patterned recess after the degreasing treatment can be effectively removed.

In some embodiments, the second development adopts a chain development process.

In some embodiments, a temperature of a developing solution in the chain development process ranges from 30°C to 35°C.

In some embodiments, a spray pressure of the developing solution in the chain development process ranges from 2 kg/cm2 to 3 kg/cm2.

In some embodiments, a speed of a chain conveyor belt in the chain development process ranges from 1.5 meters/ min to 3 meters/min. Under the conditions for the chain development process, residual photoresist at both sides of the bottom of the patterned recess after the degreasing treatment can be effectively removed, thereby effectively reducing the high proportion of copper grid line breakage and gridline false breakage.

In some embodiments, a developing solution used in the first development includes a sodium carbonate solution.

In some embodiments, after forming the copper grid lines, the method further includes a step of forming a tin protective layer on the copper grid lines by electroplating. As such, the copper grid lines can be better protected.

In some embodiments, after forming the tin protective layer, the method further includes a step of removing the negative photoresist layer and removing the copper seed layer outside a region where the copper grid lines are located.

In some embodiments, the solar cell substrate includes a silicon wafer substrate, a first intrinsic amorphous silicon layer, a second intrinsic amorphous silicon layer, an N-type doped amorphous silicon layer, a P-type doped amorphous silicon layer, a first transparent conductive film, a second transparent conductive film, a first copper seed layer, and a second copper seed layer;
wherein the first intrinsic amorphous silicon layer is disposed on a front surface of the silicon wafer substrate, and the second intrinsic amorphous silicon layer is disposed on a back surface of the silicon wafer substrate;
wherein the N-type doped amorphous silicon layer is disposed on a surface of the first intrinsic amorphous silicon layer away from the silicon wafer substrate, and the P-type doped amorphous silicon layer is disposed on a surface of the second intrinsic amorphous silicon layer away from the silicon wafer substrate;
wherein the first transparent conductive film is disposed on a surface of the N-type doped amorphous silicon layer away from the first intrinsic amorphous silicon layer, and the second transparent conductive film is disposed on a surface of the P-type doped amorphous silicon layer away from the second intrinsic amorphous silicon layer;
wherein the first copper seed layer is disposed on a surface of the first transparent conductive film away from the N-type doped amorphous silicon layer, and the second copper seed layer is disposed on a surface of the second transparent conductive film away from the P-type doped amorphous silicon layer.

In a second aspect, the present application provides a solar cell manufactured by the method described in the first aspect of the present application.

In some embodiments, the solar cell includes:
a silicon wafer substrate;
a first intrinsic amorphous silicon layer disposed on a front surface of the silicon wafer substrate;
a second intrinsic amorphous silicon layer disposed on a back surface of the silicon wafer substrate;
an N-type doped amorphous silicon layer disposed on a surface of the first intrinsic amorphous silicon layer away from the silicon wafer substrate;
a P-type doped amorphous silicon layer disposed on a surface of the second intrinsic amorphous silicon layer away from the silicon wafer substrate;
a first transparent conductive film disposed on a surface of the N-type doped amorphous silicon layer away from the first intrinsic amorphous silicon layer;
a second transparent conductive film disposed on a surface of the P-type doped amorphous silicon layer away from the second intrinsic amorphous silicon layer;
a first copper gridline electrode disposed on a surface of the first transparent conductive film away from the N-type doped amorphous silicon layer; and
a second copper gridline electrode disposed on a surface of the second transparent conductive film away from the P-type doped amorphous silicon layer.

### BRIEF DESCRIPTION OF THE DRAWINGS

In order to describe and illustrate the embodiments and/or examples of the present application more clearly, one or more attached drawings can be referred to. Additional details or examples used to describe the drawings should not be regarded as limiting the scope of any of the present application, the currently described embodiments and/or examples, and the best model of the present application as currently understood.
FIG. 1 is a scanning electron microscopy image of grid line breakage after electroplating.
FIG. 2 is a scanning electron microscopy image of gridline false breakage after electroplating.
FIG. 3 is a process flow chart of a manufacturing method in an embodiment of the present application.
FIG. 4 is a schematic view of a solar cell substrate in an embodiment of the present application.
FIG. 5 is a schematic view of reflection generated by a textured structure of a silicon wafer substrate during exposure.
FIG. 6 is a schematic view of an inverted trapezoidal recess formed after the first development.
FIG. 7 is a scanning electron microscopy image of a cross-sectional view of the inverted trapezoidal recess formed after the first development.
FIG. 8 is a scanning electron microscopy image of a side view of the inverted trapezoidal recess formed after the first development.
FIG. 9 is a scanning electron microscopy image of a cross-sectional view of a grid line formed after a first development and copper grid line electroplating.
FIG. 10 is a scanning electron microscopy image of a cross-sectional view of a patterned recess formed after a second development.
FIG. 11 is a scanning electron microscopy image of a side view of the patterned recess formed after a second development.
FIG. 12 is a scanning electron microscopy image of a cross-sectional view of a copper grid line formed after electroplating in the present application.
FIG. 13 is a schematic view of a copper grid line prepared by a conventional process under light irradiation.
FIG. 14 is a schematic view of a copper grid line prepared by the method of the present application under light irradiation.
FIG. 15 is a schematic view of a solar cell in an embodiment of the present application.

### Description of reference signs:

10. solar cell substrate; 11. silicon wafer substrate; 12. first intrinsic amorphous silicon layer; 13. second intrinsic amorphous silicon layer; 14. N-type doped amorphous silicon layer; 15. P-type doped amorphous silicon layer; 16. first transparent conductive film; 17. second transparent conductive film; 18. first copper seed layer; 19. second copper seed layer; 20. first copper gridline electrode; 21. first copper grid line; 22. first tin protective layer; 30. second copper gridline electrode; 31. second copper grid line; 32. second tin protective layer; 100. solar cell.

### DETAILED DESCRIPTION

In order to make the above objectives, features and advantages of the present application more comprehensible, specific embodiments of the present application are described in detail below. In the following description, many specific details are set forth to make the present application fully understandable. However, the present application can be implemented in many other ways different from those described herein. Similar improvements can be made by those skilled in the art without departing from the spirit of the present application. The present application is not limited to the specific embodiments disclosed below.

In addition, the terms "first" and "second" are only used for descriptive purposes and cannot be understood as indicating or implying relative importance or implicitly indicating the quantity of the indicated technical features. Therefore, the features modified by "first" or "second" may explicitly or implicitly include at least one of the features. In the description of the present application, the "plurality" means at least two, such as two, three, etc., unless otherwise specifically defined.

In the present application, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, may be directly connected to the other element or connected to the other element via an intermediate medium, or may be internal communication between two elements or interaction between two elements. For those skilled in the art, the specific meanings of the above terms in the embodiments of the present application can be understood according to specific circumstances.

Unless otherwise defined, all technical and scientific terms used herein have the same meaning as commonly understood by persons skilled in the art to which the present application belongs. The terms used in the specification of the present application are for the purpose of describing the specific embodiments only, and are not intended to limit the present application. The term "and/or" used herein includes any or all combinations of one or more of the associated listed items.

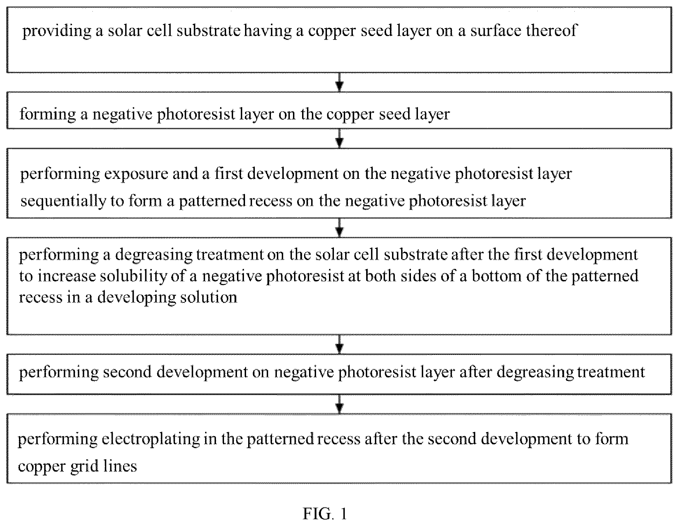

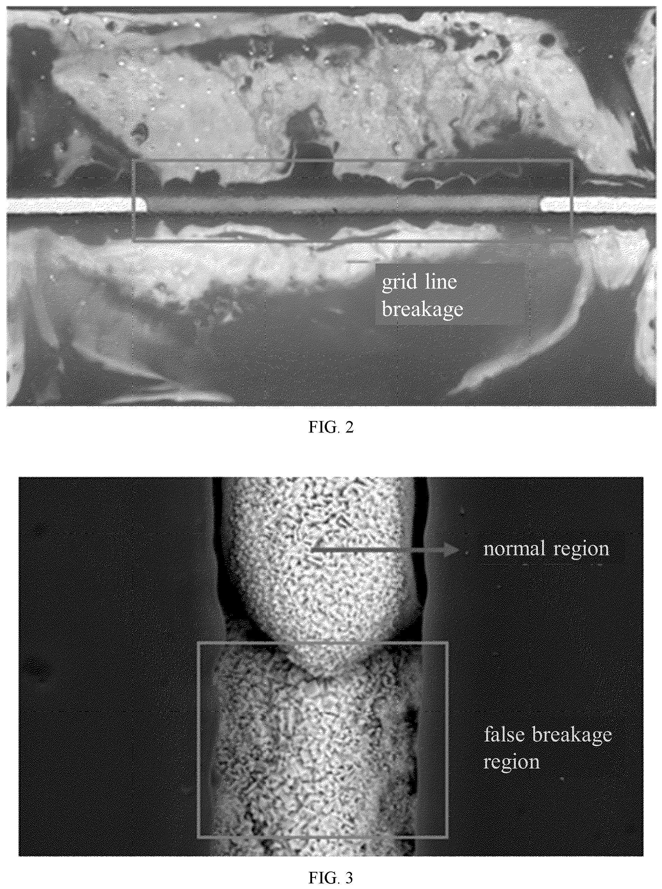

Due to consideration of production cost, during electroplating copper grid lines on solar cells, negative photoresists which are relatively inexpensive and cheaper than positive photoresists are usually used to form patterned recesses in a copper seed layer. However, when producing fine grid lines through the current copper grid line electroplating process, defects of gridline breakage or gridline false breakage occur. For copper grid lines having widths within 25 µm, the proportion of grid line breakage and gridline false breakage can be up to 90%, thereby seriously affecting the production yield and the conversion efficiency of solar cells. FIG. 1 and FIG. 2 show photos showing grid line breakage and gridline false breakage respectively. The grid line breakage refers to a situation where some grid line regions are not deposited with copper and tin. The gridline false breakage refers to a situation where some grid line regions are deposited with only tin, but not copper.

To solve the above problem, referring to FIG. 3, an embodiment of the present application provides a method for manufacturing a solar cell. The method includes the following steps S100 to S800.

Step S100: providing a solar cell substrate.

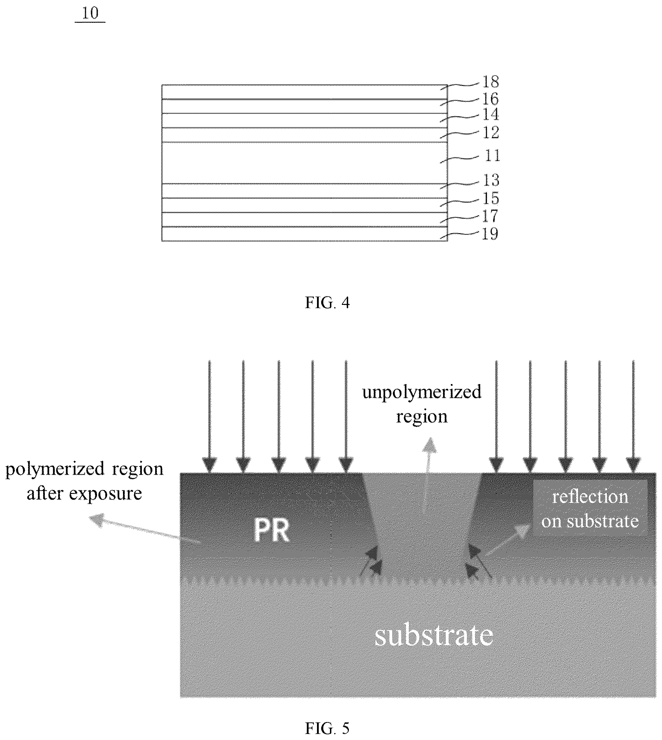

Referring to FIG. 4, in some embodiments, the solar cell substrate 10 is a Rear Emitter Si Heterojunction (RESH) solar cell substrate having a copper seed layer on a surface thereof. The solar cell substrate 10 includes a silicon wafer substrate 11, a first intrinsic amorphous silicon layer 12, a second intrinsic amorphous silicon layer 13, an N-type doped amorphous silicon layer 14, a P-type doped amorphous silicon layer 15, a first transparent conductive film 16, a second transparent conductive film 17, a first copper seed layer 18, and a second copper seed layer 19. In one specific example, the silicon wafer substrate 11 is a textured N-type crystalline silicon.

The first intrinsic amorphous silicon layer 12 is disposed on a front surface of the silicon wafer substrate 11. The second intrinsic amorphous silicon layer 13 is disposed on a back surface of the silicon wafer substrate 11. The N-type doped amorphous silicon layer 14 is disposed on a surface of the first intrinsic amorphous silicon layer 12 away from the silicon wafer substrate 11. The P-type doped amorphous silicon layer 15 is disposed on a surface of the second intrinsic amorphous silicon layer 13 away from the silicon wafer substrate 11. The first transparent conductive film 16 is disposed on a surface of the N-type doped amorphous silicon layer 14 away from the first intrinsic amorphous silicon layer 12. The second transparent conductive film 17 is disposed on a surface of the P-type doped amorphous silicon layer 15 away from the second intrinsic amorphous silicon layer 13. The first copper seed layer 18 is disposed on a surface of the first transparent conductive film 16 away from the N-type doped amorphous silicon layer 14. The second copper seed layer 19 is disposed on a surface of the second transparent conductive film 17 away from the P-type doped amorphous silicon layer 15.

In some embodiments, the solar cell substrate 10 is prepared as follows. First, the silicon wafer substrate 11 is subjected to texturing and cleaning treatments to form a uniform "pyramid" textured surface on the surface of the silicon wafer substrate 11. Then, a first intrinsic amorphous silicon layer 12 and an N-type doped amorphous silicon layer 14 are deposited in sequence on the front surface of the silicon wafer substrate 11. A second intrinsic amorphous silicon layer 13 and a P-type doped amorphous silicon layer 15 are deposited in sequence on the back surface of the silicon wafer substrate 11. Then, a first transparent conductive film 16 and a second transparent conductive film 17 are deposited on the N-type doped amorphous silicon layer 14 and the P-type doped amorphous silicon layer 15, respectively. Last, a first copper seed layer 18 and a second copper seed layer 19 are deposited on the first transparent conductive film 16 and the second transparent conductive film 17, respectively.

Step S200: forming a negative photoresist layer on the copper seed layer.

In some embodiments, a negative photoresist is uniformly coated on the first copper seed layer 18 on the front surface and on the second copper seed layer 19 on the back side of the solar cell substrate 10 to form the negative photoresist layer.

Generally, the negative photoresist is primarily made of a photo-initiator, alkali-soluble macromolecules, and non-alkali-soluble reactive monomers. Upon exposure to ultraviolet light, the photo-initiator in the exposed portion of the negative photoresist decomposes, which generates free radicals to trigger a polymerization reaction. The polymerized coating portion forms a three-dimensional network structure due to increased molecular weight, and shows decreased solubility in dilute alkaline solutions (such as a developing solution), thereby generating insolubility. The coating portion unexposed to ultraviolet light does not undergo the cross-linking and polymerization reaction, and alkali-soluble hydrophilic groups (such as-COOH) therein can react with an alkaline solution, thereby capable of being soluble.

In embodiments of the present application, a negative photoresist is used to form a negative photoresist layer on the copper seed layer. Compared to the positive photoresist, the negative photoresist is cheaper and has lower production costs, thereby being conducive to large-scale mass production. It can be understood that the negative photoresist used in the embodiments of the present application can be a negative photoresist material commonly used in the art, and the specific composition and type of the negative photoresist are not limited in the present application.

Step S300: performing patterned exposure on the negative photoresist layer.

In some embodiments, a designed grid line pattern is laser-printed onto the negative photoresist layer, and the negative photoresist layer in designated non-grid line regions is exposed to ultraviolet light. Under the action of ultraviolet light, polymerizable monomer molecules in the negative photoresist layer undergo a series of cross-linking and polymerization reactions after exposure, forming polymers in the exposed region that are insoluble in weakly alkaline solutions, such as a developing solution. After subsequent development process, the negative photoresist layer in the unexposed region is removed, while the negative photoresist layer in the exposed region remains, thereby forming a circuit pattern on the negative photoresist layer.

Step S400: performing a first development on the exposed negative photoresist layer.

In some embodiments, the negative photoresist layer in the unexposed region is removed by washing with a weakly alkaline Na₂CO₃ solution, i.e., the developing solution, to expose the underlying copper seed layer, thereby forming a patterned recess in the negative photoresist layer. After exposure to ultraviolet light, the photo-initiator in the exposed portion of the negative photoresist decomposes, which generates free radicals to trigger a polymerization reaction. The polymerized coating portion forms a three-dimensional network structure, and shows decreased solubility in dilute alkaline solutions (such as Na₂CO₃ solution), thereby generating insolubility. The coating portion unexposed to ultraviolet light does not undergo the cross-linking and polymerization reaction, and alkali-soluble hydrophilic groups (such as-COOH) therein can react with an alkaline solution, thereby capable of being dissolved and removed.

Step S500: performing a degreasing treatment on the solar cell substrate 10 after the first development.

It is discovered by research that the main reason for an excessively high proportion of copper grid line breakage and gridline false breakage occurs during manufacturing solar cell grid lines through the conventional copper electroplating process is in that a large amount of residual photoresist exists at the bottom of the patterned recess formed after exposing and first development of the negative photoresist layer, which results in a decrease in the width of the bottom of the patterned recess, and that copper grid lines cannot be deposited on the bottom of the patterned recess during electroplating, thereby causing that finished solar cells exhibited a high proportion of grid line breakage and gridline false breakage, and affecting the production yield and the conversion efficiency of solar cells.

Further, it is discovered by research that the reason for a large amount of residual photoresist exists at the bottom of the patterned recess formed after development is in that the silicon wafer substrate 11 of the solar cell substrate 10 has an uneven "pyramid" textured structure, which can generate light reflection to some extent when the laser arrivals during exposure, thereby resulting in the non-exposed region at the bottom of the patterned recess undergoes slight photosensitive cross-linking and polymerization caused by the light reflected by the textured structure; meanwhile, when the grid line is relatively thin (that is, the non-exposed region is relatively narrow), many foams are generated by spraying the developing solution (i.e., Na₂CO₃ solution) during development, which results in relatively weak development effect at both sides of the bottom of the patterned recess. Therefore, these two factors lead to the presence of a large amount of residual photoresist at both sides of the bottom of the patterned recess after development, forming a morphological structure of an "inverted trapezoidal" recess.

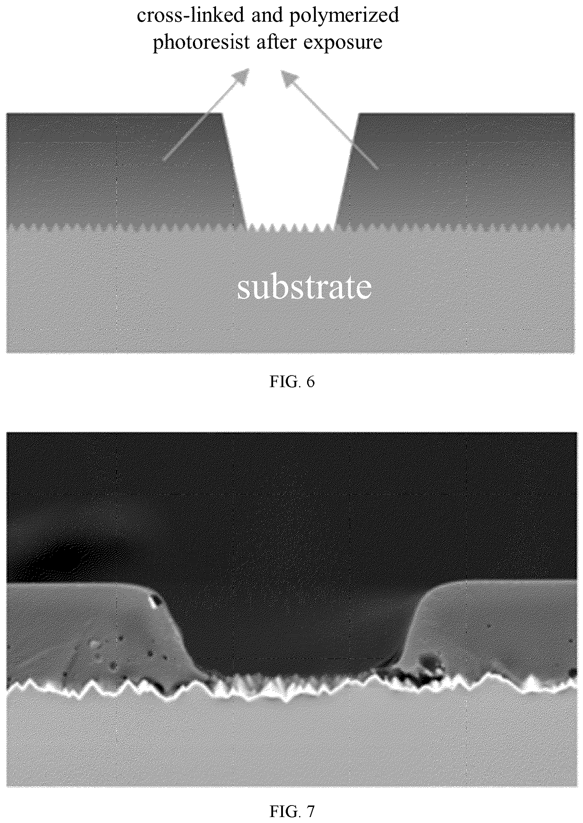

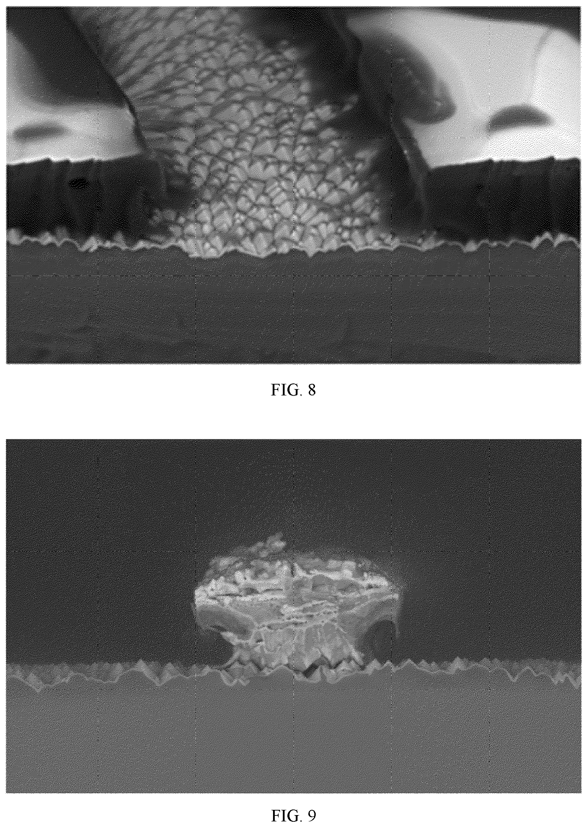

FIG. 5 is a schematic view of the reflection generated by the pyramidal textured structure during exposure, where Photo Resist (PR) represents the photo-sensitive resist. FIG. 6 is a schematic view of a morphological structure of the inverted trapezoidal recess after the first development. FIG. 7 and FIG. 8 are scanning electron microscopy images of a cross-sectional view and a side view of the inverted trapezoidal recess structure after the first development, respectively. FIG. 9 is a scanning electron microscopy image of a cross-sectional view of the grid lines formed after the first development and copper grid line electroplating.

As shown in FIGS. 5, 6, 7, and 8, during exposure, the light reflected from the pyramidal textured structure of the silicon wafer substrate causes the negative photoresist layer at both sides of the bottom of the patterned recess to slightly generate a cross-linking and polymerization reaction, so that the negative photoresist formed at both sides of the bottom of the patterned recess through slightly cross-linking and polymerization is difficult to be removed during the development, and residual photoresist is formed. As shown in FIG. 9, the copper grid line formed after first development and electroplating through the conventional process has a cross-sectional morphology that is wide at the top and narrow at the bottom. The bottom of the copper grid line with such a morphology has a relatively small contact area with the copper seed layer, which likely causes situations of grid line breakage and gridline false breakage. The copper grid lines also have a large light-shielding area and can reflect light, thereby affecting the conversion efficiency of solar cells.

In order to solve the above problem, in an embodiment of the present application, after the first development, the solar cell substrate 10 is further subjected to a degreasing treatment, so as to greatly increase the solubility of the slightly exposed residual photoresist at both sides of the bottom of the patterned recess formed after the first development in the developing solution, thereby facilitating the removal of the residual photoresist at both sides of the bottom of the patterned recess by subsequent development.

In some embodiments, the solar cell substrate 10 is treated with a degreasing solution containing a degreasing agent. In some specific examples, the solar cell substrate 10 after the first development treatment can be immersed in the degreasing solution containing the degreasing agent. Alternatively, the degreasing solution containing the degreasing agent can be sprayed or applied to the solar cell substrate 10. The degreasing agent primarily includes a surfactant, which has a range of functions, including dispersing, solubilizing, cleaning, wetting, degreasing, defoaming, etc. The degreasing agent can significantly increase the solubility of the slightly exposed residual photoresist at both sides of the bottom of the patterned recess formed after the first development.

It should be noted that the degreasing agent can be a commercially available product. The surfactant in the degreasing agent can also be an existing surfactant product. The type of the surfactant in the degreasing agent can be a single surfactant or a combination of multiple surfactants, as long as they can perform functions such as dispersing, solubilizing, cleaning, wetting, degreasing, defoaming or the like to increase the solubility of residual photoresist in the developing solution.

In some embodiments, the degreasing solution further contains sulfuric acid. By adding sulfuric acid into the degreasing solution, the oxide layer on the surface of the copper seed layer at the bottom of the patterned recess can be effectively removed, which is conducive to electroplating copper grid lines on the copper seed layer in the patterned recess.

In some embodiments, a volume fraction of sulfuric acid in the degreasing solution ranges from 0.5% to 2.5%, and a volume fraction of the degreasing agent in the degreasing solution ranges from 0.5% to 3%. Under these volume fraction ranges, the degreasing agent and sulfuric acid can effectively increase the solubility of residual photoresist at both sides of the bottom of the patterned recess in the developing solution, and more effectively remove the oxide layer on the surface of the copper seed layer at the bottom of the patterned recess, thereby effectively reducing the high proportion of copper grid line breakage and gridline false breakage.

It can be understood that the volume fraction of sulfuric acid in the degreasing solution can be, but is not limited to, 0.5%, 0.6%, 0.7%, 0.8%, 0.9%, 1.0%, 1.1%, 1.2%, 1.3%, 1.4%, 1.5%, 1.6%, 1.7%, 1.8%, 1.9%, 2.0%, 2.1%, 2.2%, 2.3%, 2.4%, or 2.5%. The volume fraction of the degreasing agent in the degreasing solution can be, but is not limited to, 0.5%, 0.6%, 0.7%, 0.8%, 0.9%, 1.0%, 1.1%, 1.2%, 1.3%, 1.4%, 1.5%, 1.6%, 1.7%, 1.8%, 1.9%, 2.0%, 2.1%, 2.2%, 2.3%, 2.4%, 2.5%, 2.6%, 2.7%, 2.8%, 2.9%, or 3%.

In a specific example, the volume fraction of sulfuric acid in the degreasing solution is 1%; and the volume fraction of the degreasing agent in the degreasing solution is 1.6%.

In some embodiments, the degreasing agent is a surfactant, and the degreasing solution is prepared from the degreasing agent, sulfuric acid, and a solvent. Conventional degreasing agents are commonly used in printed circuit board (PCB) electroplating processes. It is found by research that in the present application, the use of conventional degreasing agents can lead to a decrease in the conversion efficiency of the solar cell, although the use of conventional degreasing agents can increase the solubility of the negative photoresist at both sides of the bottom of the patterned recess in the developing solution, and thus reduce the proportion of electroplated copper grid line breakage and gridline false breakage for the solar cell, thereby improving the product yield.

Therefore, in some embodiments of the present application, a specific degreasing agent that only retains the surfactant but removes other components in the conventional degreasing agent is utilized. The degreasing solution includes the degreasing agent described above, sulfuric acid, and a solvent. By using the specific degreasing solution for the degreasing treatment, it not only reduces the proportion of electroplated copper grid line breakage and gridline false breakage for the solar cell, improving the product yield, but also further enhances the conversion efficiency of solar cells.

It can be understood that the solvent in the degreasing solution can be a solvent commonly used in the art. In some embodiments, the solvent in the degreasing solution is water.

In a specific example, the degreasing agent used is a product with a catalog number of TYJ001 produced by Suzhou Sunwell New Energy Co., Ltd.

In some embodiments, during the degreasing treatment, a temperature of the degreasing solution ranges from 35°C to 45°C, and a time period for the degreasing treatment ranges from 15 seconds to 30 seconds. Under the temperature and time period conditions, the oxide layer on the surface of the copper seed layer can be effectively removed, and the solubility of residual photoresist at both sides of the bottom of the patterned recess can be effectively increased. It can be understood that the temperature of the degreasing solution can be, but is not limited to, 35°C, 36°C, 37°C, 38°C, 39°C, 40°C, 41°C, 42°C, 43°C, 44°C, or 45°C; and the time period for the degreasing treatment can be, but is not limited to, 15 seconds, 16 seconds, 18 seconds, 20 seconds, 22 seconds, 24 seconds, 26 seconds, 28 seconds, or 30 seconds.

Step S600: performing a second development on the negative photoresist layer on the solar cell substrate 10 after the degreasing treatment.

In an embodiment of the present application, after the degreasing treatment, the negative photoresist layer on the solar cell substrate 10 is subjected to a second development. Through the second development, the residual photoresist at both sides of the bottom of the patterned recess whose solubility is increased after the degreasing treatment can be effectively removed, so that the patterned recess forms a positive trapezoidal opening morphology after the development, which ensures that copper is in a good contact with the copper seed layer at the bottom of the patterned recess during subsequent copper grid line electroplating, thereby forming copper grid lines with a positive trapezoidal cross-sectional morphology after electroplating.

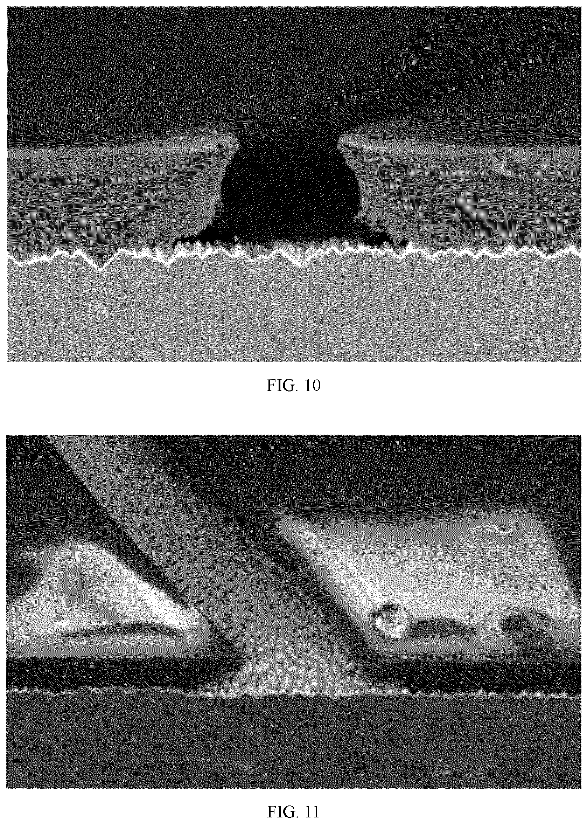

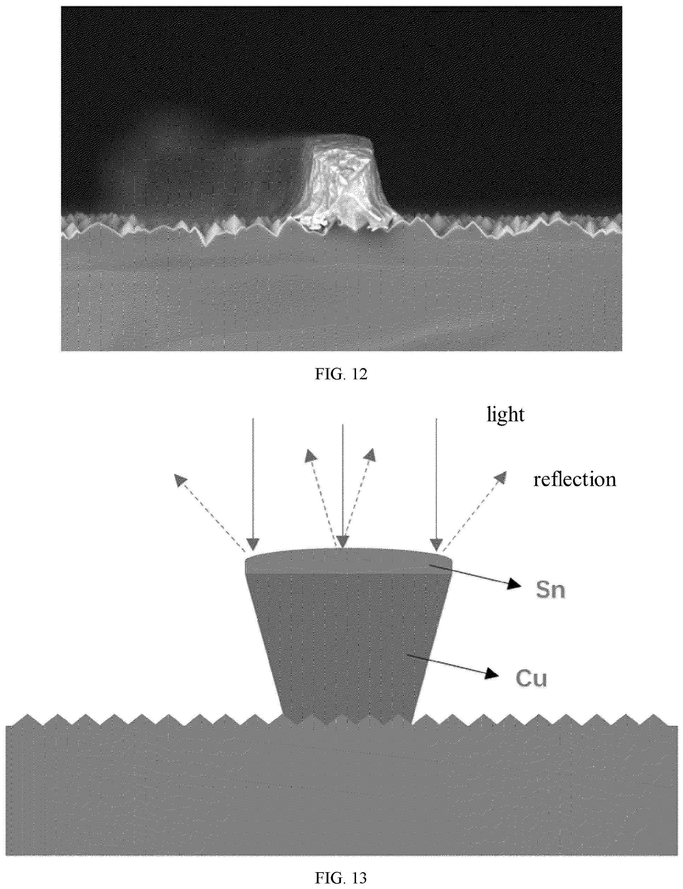

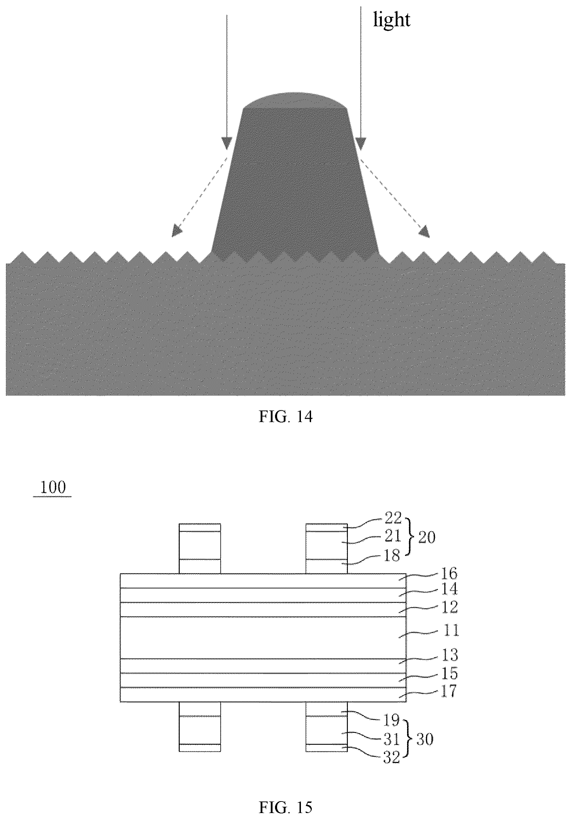

FIG. 10 is a scanning electron microscopy image of a cross-sectional view of the patterned recess formed after the second development. FIG. 11 is a scanning electron microscopy image of a side view of the patterned recess. FIG. 12 is a scanning electron microscopy image of a cross-sectional view of the copper grid line formed after electroplating in the present application. FIG. 13 is a schematic view of the copper grid line prepared by the conventional process under light irradiation. FIG. 14 is a schematic view of the copper grid line formed after the second development in the present application under light irradiation.

As can be seen from FIG. 10 and FIG. 11, after the degreasing treatment and the second development, a graphic recess with a right trapezoidal cross-section that is wider at the bottom and narrower at the top can be formed. As can be seen from FIG. 12, after electroplating in the graphic recess with the right trapezoidal cross-section, a copper grid line with a right trapezoidal cross-section morphology can be formed. As can be seen from FIG. 13, the copper grid line with an inverted trapezoidal cross-section prepared by the conventional process has a grid line morphology that is wide at the top and narrow at the bottom, so that the contact area between the bottom of the grid line and the copper seed lay is easy to generate grid-line breakage and gridline false breakage; meanwhile, the grid line has a large light-shielding area and can reflect light, thereby affecting the conversion efficiency of the solar cell. As can be seen from FIG. 14, the copper grid line formed in the present application has a cross-sectional morphology that is narrow at the top and wide at the bottom, so that the contact area between the bottom of the grid line and the copper seed layer is large, which is less likely to generate grid-line breakage and gridline false breakage; meanwhile, the grid line has a small light-shielding area and reflects less light, thereby improving the conversion efficiency of the solar cell.

In some embodiments, the developing solution for the second development includes one or more of a sodium carbonate solution and a potassium carbonate solution with a concentration of 10 g/L to 15 g/L. The second development adopts a chain development process, including conditions: a temperature of the developing solution ranging from 30°C to 35°C, a spray pressure for the developing solution ranging from 2 kg/cm² to 3 kg/cm², and a belt speed ranging from 1.5 meters/min to 3 meters/min. Under these conditions, residual photoresist at both sides of the bottom of the patterned recess after the degreasing treatment can be effectively removed, thereby effectively reducing the high proportion of copper grid line breakage and gridline false breakage.

It can be understood that, during the second development, the temperature of the developing solution can be, but is not limited to, 30°C, 31°C, 32°C, 33°C, 34°C, or 35°C; the spray pressure for the developing solution can be, but is not limited to, 2 kg/cm², 2.2 kg/cm², 2.4 kg/cm², 2.6 kg/cm², 2.8 kg/cm², or 3 kg/cm²; the belt speed can be, but is not limited to, 1.5 meters/min, 1.8 meters/min, 2.0 meters/min, 2.2 meters/min, 2.4 meters/min, 2.6 meters/min, 2.8 meters/min, or 3 meters/min; and the concentrations of the sodium carbonate solution and the potassium carbonate solution can be, but are not limited to, 10 g/L, 11 g/L, 12 g/L, 13 g/L, 14 g/ L, or 15 g/L.

In some embodiments, after the negative photoresist layer on the solar cell substrate 10 is subjected to a second development, the method further includes washing and drying the solar cell substrate 10, so as to increase the cleanliness of the solar cell substrate 10 and the patterned recess, which is more conducive to the subsequent electroplating of copper grid lines.

Step S700: performing electroplating in the patterned recess after the second development to form copper grid lines.

After the second development, the solar cell substrate 10 is placed in an electroplating solution for copper electroplating, thereby forming copper grid lines on the copper seed layer in the patterned recess. It should be noted that the electroplating in the patterned recess can be performed by using conventional electroplating processes in the art to form the copper grid lines. The process conditions for electroplating the copper grid lines are not specifically defined in the present application.

In some embodiments, after the copper grid lines are formed by electroplating, the method further includes electroplating to form a tin protective layer on the copper grid lines. As such, the copper grid lines can be better protected. Similarly, the tin protective layer can be formed by electroplating on the copper grid lines by using conventional electroplating processes in the art. The process conditions for electroplating the tin protective layer are not specifically defined in the present application.

Step S800: removing the negative photoresist layer on the solar cell substrate 10, and removing the copper seed layer outside a region where the copper grid lines are located on the solar cell substrate 10.

In the present application, after the copper grid lines are formed in the patterned recess by electroplating, the negative photoresist layer on the solar cell substrate 10 is removed, and the copper seed layer outside a region where the copper grid lines are located on the solar cell substrate 10 is also removed, so that the transparent conductive film outside the region where the copper grid lines are located is exposed, thereby obtaining a complete solar cell.

An embodiment of the present application provides a solar cell produced by the method for manufacturing a solar cell in the first aspect of the present application. Compared to solar cells produced by using conventional processes, the solar cell of the present application exhibits significantly reduced proportion of copper grid line breakage and gridline false breakage, and improved conversion efficiency.

Referring to FIG. 15, in some embodiments, the solar cell 100 includes a silicon wafer substrate 11, a first intrinsic amorphous silicon layer 12, a second intrinsic amorphous silicon layer 13, an N-type doped amorphous silicon layer 14, a P-type doped amorphous silicon layer 15, a first transparent conductive film 16, a second transparent conductive film 17, a first copper gridline electrode 20, and a second copper gridline electrode 30.

The silicon wafer substrate 11 is an N-type crystalline silicon having a "pyramid" textured structure on the surface after a texturing treatment. The first intrinsic amorphous silicon layer 12 is disposed on a front surface of the silicon wafer substrate 11. The second intrinsic amorphous silicon layer 13 is disposed on a back surface of the silicon wafer substrate 11. An N-type doped amorphous silicon layer 14 is disposed on a surface of the first intrinsic amorphous silicon layer 12 away from the silicon wafer substrate 11. A P-type doped amorphous silicon layer 15 is disposed on a surface of the second intrinsic amorphous silicon layer 13 away from the silicon wafer substrate 11. A first transparent conductive film 16 is disposed on a surface of the N-type doped amorphous silicon layer 14 away from the first intrinsic amorphous silicon layer 12. A second transparent conductive film 17 is disposed on a surface of the P-type doped amorphous silicon layer 15 away from the second intrinsic amorphous silicon layer 13. A first copper gridline electrode 20 is disposed on a surface of the first transparent conductive film 16 away from the N-type doped amorphous silicon layer 14. A second copper gridline electrode 30 is disposed on a surface of the second transparent conductive film 17 away from the P-type doped amorphous silicon layer 15. The first copper gridline electrode 20 includes a first copper seed layer 18 in contact with the first transparent conductive film 16, a first copper grid line 21 formed on the first copper seed layer 18, and a first tin protective layer 22 formed on the first copper grid line 21. The second copper gridline electrode 30 includes a second copper seed layer 19 in contact with the second transparent conductive film 17, a second copper grid line 31 formed on the second copper seed layer 19, and a second tin protective layer 32 formed on the second copper grid line 31.

In summary, after the first development and prior to the copper grid electroplating, the method for manufacturing the solar cell 100 in the present application further includes performing the degreasing treatment and the second development, so that the residual photoresist at both sides of the bottom of the patterned recess that has subjected to the first development can be effectively removed, which increases the contact area between the bottom of the copper grid lines and the copper seed layer, and thus reduces the copper grid line breakage and the gridline false breakage. Meanwhile, the cross-sectional morphology of the copper grid lines can be changed to a regular trapezoidal morphology with a narrow top and a wide bottom, which reduces the light-shielding area of the copper grid lines and light reflection. Therefore, the manufacturing method of the present application can effectively improve the production yield of the solar cell 100 and the photoelectric conversion efficiency of the solar cell.

Compared to conventional manufacturing processes, the manufacturing method of the present application significantly reduces the copper grid line breakage and the gridline false breakage, while optimizing the copper grid line morphology and enabling thin-line production. Under the condition that the production yield does not decrease, the grid lines can be made thinner, which can significantly increase production yield at the same grid line width. Meanwhile, the fill factor (FF) and the short-circuit current (Isc) of the solar cell 100 can also be improved, thereby increasing the conversion efficiency (Eta) of the solar cell. When the grid line width is 20 µm, compared to conventional manufacturing methods, the manufacturing method of the present application can increase the fill factor of the solar cell 100 by about 1.2%, the short-circuit current by about 40 mA, and the conversion efficiency by about 0.4%, and reduce the copper grid line breakage and the gridline false breakage by about 90%.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims, and the specification and drawings can be used to explain the content of the claims.

## Claims

1. A method for manufacturing a solar cell, comprising the following steps:
providing a solar cell substrate having a copper seed layer on a surface thereof;
forming a negative photoresist layer on the copper seed layer;
performing exposure and a first development on the negative photoresist layer sequentially to form a patterned recess on the negative photoresist layer;
performing a degreasing treatment on the solar cell substrate after the first development, so as to increase solubility of a negative photoresist at both sides of a bottom of the patterned recess in a developing solution;
performing a second development on the negative photoresist layer after the degreasing treatment; and
performing electroplating in the patterned recess after the second development to form copper grid lines.

2. The method for manufacturing the solar cell according to claim 1, wherein the degreasing treatment comprises a step of treating the solar cell substrate with a degreasing solution containing a degreasing agent.

3. The method for manufacturing the solar cell according to claim 2, wherein the degreasing agent comprises a surfactant.

4. The method for manufacturing the solar cell according to claim 2 or 3, wherein a volume fraction of the degreasing agent in the degreasing solution ranges from 0.5% to 3%.

5. The method for manufacturing the solar cell according to any one of claims 2 to 4, wherein the degreasing solution further comprises sulfuric acid.

6. The method for manufacturing the solar cell according to claim 5, wherein a volume fraction of the sulfuric acid in the degreasing solution ranges from 0.5% to 2.5%.

7. The method for manufacturing the solar cell according to any one of claims 2 to 6, wherein the degreasing agent is a surfactant, and the degreasing solution consists of the degreasing agent, sulfuric acid, and a solvent.

8. The method for manufacturing the solar cell according to claim 7, wherein the solvent in the degreasing solution is water.

9. The method for manufacturing the solar cell according to any one of claims 2 to 8, wherein a temperature of the degreasing solution in the degreasing treatment ranges from 35°C to 45°C.

10. The method for manufacturing the solar cell according to any one of claims 1 to 9, wherein a time period for the degreasing treatment ranges from 15 seconds to 30 seconds.

11. The method for manufacturing the solar cell according to any one of claims 1 to 10, wherein a developing solution used in the second development comprises one or more of a sodium carbonate solution and a potassium carbonate solution.

12. The method for manufacturing the solar cell according to any one of claims 1 to 11, wherein a concentration of a developing solution used in the second development ranges from 10 g/L to 15 g/L.

13. The method for manufacturing the solar cell according to any one of claims 1 to 11, wherein the second development adopts a chain development process.

14. The method for manufacturing the solar cell according to claim 13, wherein a temperature of a developing solution in the chain development process ranges from 30°C to 35°C.

15. The method for manufacturing the solar cell according to claim 13 or 14, wherein a spray pressure of the developing solution in the chain development process ranges from 2 kg/cm² to 3 kg/cm².

16. The method for manufacturing the solar cell according to any one of claims 13 to 15, wherein a speed of a chain conveyor belt in the chain development process ranges from 1.5 meters/ min to 3 meters/min.

17. The method for manufacturing the solar cell according to any one of claims 1 to 16, wherein a developing solution used in the first development comprises a sodium carbonate solution.

18. The method for manufacturing the solar cell according to any one of claims 1 to 17, wherein after forming the copper grid lines, the method further comprises a step of forming a tin protective layer on the copper grid lines by electroplating.

19. The method for manufacturing the solar cell according to claim 18, wherein after forming the tin protective layer, the method further comprises a step of removing the negative photoresist layer and removing the copper seed layer outside a region where the copper grid lines are located.

20. The method for manufacturing the solar cell according to any one of claims 1 to 19, wherein the solar cell substrate comprises a silicon wafer substrate, a first intrinsic amorphous silicon layer, a second intrinsic amorphous silicon layer, an N-type doped amorphous silicon layer, a P-type doped amorphous silicon layer, a first transparent conductive film, a second transparent conductive film, a first copper seed layer, and a second copper seed layer;
wherein the first intrinsic amorphous silicon layer is disposed on a front surface of the silicon wafer substrate, and the second intrinsic amorphous silicon layer is disposed on a back surface of the silicon wafer substrate;
wherein the N-type doped amorphous silicon layer is disposed on a surface of the first intrinsic amorphous silicon layer away from the silicon wafer substrate, and the P-type doped amorphous silicon layer is disposed on a surface of the second intrinsic amorphous silicon layer away from the silicon wafer substrate;
wherein the first transparent conductive film is disposed on a surface of the N-type doped amorphous silicon layer away from the first intrinsic amorphous silicon layer, and the second transparent conductive film is disposed on a surface of the P-type doped amorphous silicon layer away from the second intrinsic amorphous silicon layer;
wherein the first copper seed layer is disposed on a surface of the first transparent conductive film away from the N-type doped amorphous silicon layer, and the second copper seed layer is disposed on a surface of the second transparent conductive film away from the P-type doped amorphous silicon layer.

21. A solar cell manufactured by the method according to any one of claims 1 to 20.

22. The solar cell according to claim 21, comprising:
a silicon wafer substrate;
a first intrinsic amorphous silicon layer disposed on a front surface of the silicon wafer substrate;
a second intrinsic amorphous silicon layer disposed on a back surface of the silicon wafer substrate;
an N-type doped amorphous silicon layer disposed on a surface of the first intrinsic amorphous silicon layer away from the silicon wafer substrate;
a P-type doped amorphous silicon layer disposed on a surface of the second intrinsic amorphous silicon layer away from the silicon wafer substrate;
a first transparent conductive film disposed on a surface of the N-type doped amorphous silicon layer away from the first intrinsic amorphous silicon layer;
a second transparent conductive film disposed on a surface of the P-type doped amorphous silicon layer away from the second intrinsic amorphous silicon layer;
a first copper gridline electrode disposed on a surface of the first transparent conductive film away from the N-type doped amorphous silicon layer; and
a second copper gridline electrode disposed on a surface of the second transparent conductive film away from the P-type doped amorphous silicon layer.
